# FASCICULE DE BREVET EUROPEEN

(11) **EP 3 538 500 B1**
(45) Date de publication et mention de la délivrance du brevet: **24.01.2024**
(21) Numéro de dépôt: 17804614.0
(22) Date de dépôt: 31.10.2017
(51) Int. Cl.: C04B 41/87, C04B 41/89, F01D 5/28

(54) **PIECE DE TURBOMACHINE REVETUE D'UNE BARRIERE THERMIQUE ET PROCEDE POUR L'OBTENIR.**
MIT EINER WÄRMEDÄMMUNG BESCHICHTETES TURBOMASCHINENTEIL UND VERFAHREN ZUR HERSTELLUNG DAVON
TURBOMACHINE PART COATED WITH A THERMAL BARRIER AND PROCESS FOR OBTAINING SAME

(30) Priorité: 09.11.2016 FR 1660849
(43) Date de publication de la demande: 18.09.2019
(73) Titulaire: Safran, 75015 Paris (FR); Safran Aircraft Engines, 75015 Paris (FR); Université Paul Sabatier Toulouse III, 31062 Toulouse (FR); Centre National de la Recherche Scientifique, 75016 Paris (FR)
(72) Inventeur: JOULIA, Aurélien, 77550 Moissy-Cramayel (FR); MALIE, André, Hubert, Louis, 77550 Moissy-Cramayel (FR); ANSART, Florence, 31670 Labege (FR); DELON, Elodie, Marie, 31120 Portet-sur-Garonne (FR); DULUARD, Sandrine, 31500 Toulouse (FR)
(74) Mandataire: Cabinet Beau de Loménie
(86) Numéro de dépôt international: PCT/FR2017/052996
(87) Numéro de publication internationale: WO 2018/087452

(56) Documents cités:
- EP-A2- 2 644 747
- US-A1- 2016 273 089
- BERNDT C C ET AL: "The manufacture and microstructure of fiber-reinforced thermally sprayed coatings", SURFACE AND COATINGS TECHNOLOGY, ELSEVIER BV, AMSTERDAM, NL, vol. 37, no. 1, 1 février 1989 (1989-02-01), pages 89-110, XP025805482, ISSN: 0257-8972, DOI: 10.1016/0257-8972(89)90123-0 [extrait le 1989-02-01]

## Description

### Arrière-plan de l'invention

La présente invention se rapporte au domaine général des revêtements de barrière thermique utilisés pour isoler thermiquement des pièces dans des environnements à haute température. L'invention s'applique plus particulièrement aux barrières thermiques utilisées pour protéger les pièces en superalliages ou en matériau composite à matrice céramique des turbines à gaz aéronautiques.

Les pièces présentes dans des parties chaudes des turbomachines aéronautiques opérant en milieu désertique, ou très pollué, se dégradent rapidement à cause de l'attaque du sable et des composés alcalins présents dans l'air ingéré par le moteur. Ces composés, connus sous le nom d'aluminosilicates de calcium et de magnésium, ou « CMAS » (regroupant notamment des oxydes de calcium, de magnésium, d'aluminium et de silicium), peuvent dégrader le revêtement jouant le rôle de barrière thermique recouvrant certaines pièces des parties chaudes de la turbomachine.

Parmi les mécanismes de dégradation de la barrière thermique par les composés CMAS, on distingue notamment l'infiltration à l'état liquide des composés CMAS dans la barrière thermique, et la dissolution-reprécipitation de la barrière thermique (constituée traditionnellement d'une céramique à base de zircone stabilisée à l'yttrine YSZ), en nodules isolés de zircone appauvris en yttrine. Ces deux mécanismes abaissent les propriétés mécaniques de la barrière thermique qui peut conduire à sa fissuration au cours des phases de refroidissement du moteur. De plus, l'ingestion de particules solides créée des phénomènes d'érosion de la barrière thermique qui s'écaille et laisse alors le substrat sous-jacent à nu, réduisant ainsi la durée de vie des pièces.

Il existe donc un besoin pour une pièce de turbomachine revêtue d'une barrière thermique qui présente des propriétés de résistance aux CMAS et une durée de vie améliorée. Il existe aussi un besoin pour disposer d'un procédé de fabrication d'une telle pièce qui soit de coût de mise en oeuvre réduit.

Le document EP 2 644 747 A décrit une pièce de turbomachine revêtue d'une couche comprenant un matériau céramique et des fibres céramiques.

### Objet et résumé de l'invention

La présente invention a donc pour but principal de pallier de tels inconvénients en proposant une pièce de turbomachine revêtue d'au moins une première couche de barrière thermique comprenant un matériau céramique et des premières fibres céramiques dispersées dans ladite première couche.

La présence des premières fibres céramiques dans la première couche de barrière thermique de la pièce selon l'invention permet d'augmenter la résistance mécanique de la barrière thermique et sa résistance aux composés CMAS. Ces fibres céramiques permettent de renforcer la barrière thermique et de réduire la propagation de fissures pouvant être générées simultanément par l'oxydation cyclique de la barrière lors du fonctionnement de la turbomachine et son attaque par des composés CMAS. En somme, les fibres céramiques jouent le rôle de renforts dans la première couche de barrière thermique permettant d'améliorer ses propriétés mécaniques intrinsèques. Les fibres céramiques peuvent également présenter des propriétés de résistance aux matériaux CMAS.

Dans un exemple de réalisation, la teneur massique en premières fibres céramiques dans la première couche peut être comprise entre 30% et 90%. Par exemple, la teneur massique en premières fibres céramiques dans la première couche peut être comprise entre 50% et 90%, voire entre 70% et 90%. De manière générale, la teneur en premières fibres céramiques dans la première couche céramique sera suffisante pour assurer la fonction de renfort mécanique.

Dans un exemple de réalisation, la longueur moyenne des premières fibres céramiques peut être inférieure ou égale à 50 µm. Par longueur moyenne, on entend la longueur D50 des fibres.

Dans un exemple de réalisation, l'épaisseur moyenne de la première couche de barrière thermique est comprise entre 100 µm et 200 µm.

Dans un exemple de réalisation, le matériau céramique de la première couche peut être de la zircone stabilisée par un oxyde de terre rare, par exemple de la zircone stabilisée ou partiellement stabilisée à l'Yttrine (YSZ ou 8YSZ).

Dans un exemple de réalisation, les premières fibres céramiques peuvent être constituées d'un matériau choisi parmi les suivants : la zircone stabilisée par un oxyde de terre rare, les oxydes de terres rares, les structures pyrochlores, les zirconates de terres rares, l'alumine Al₂O₃, et leurs mélanges. Dans un exemple de réalisation, les premières fibres céramiques peuvent comprendre un matériau de protection contre les aluminosilicates de calcium et de magnésium afin de renforcer encore la couche de barrière thermique contre les composés CMAS. Par exemple, les fibres peuvent comprendre un mélange d'alumine et d'au moins un zirconate de terre rare afin de renforcer chimiquement la première couche de barrière thermique contre les composés CMAS, notamment lorsque celle-ci comprend de la zircone yttriée partiellement stabilisée.

Dans un exemple de réalisation, les premières fibres céramiques peuvent être constituées du même matériau que celui de la première couche de barrière thermique.

Dans un exemple de réalisation, l'écart entre le coefficient de dilatation thermique du matériau de la première couche et le coefficient de dilatation thermique du matériau des premières fibres céramiques peut être inférieur ou égal à 4.10⁻⁶ K⁻¹, voire inférieur ou égal à 2.10⁻⁶ K⁻¹.

Dans un exemple de réalisation, la pièce revêtue peut en outre comprendre une sous-couche d'accrochage disposée entre un substrat et la première couche de barrière thermique. En particulier, lorsque le substrat est un superalliage (par exemple un superalliage à base de fer, de cobalt ou de nickel), la sous-couche peut comprendre un aluminiure simple ou modifié (par exemple NiAI ou NiCrAIY pour un substrat en superalliage à base de nickel). En variante, lorsque le substrat est un matériau composite à matrice céramique (CMC), la sous-couche d'accrochage peut comprendre du silicium, et par exemple être formée de silicium ou d'un siliciure métallique.

Dans un exemple de réalisation, la pièce peut en outre être revêtue par une deuxième couche céramique comprenant un matériau céramique de protection contre les aluminosilicates de calcium et de magnésium, la deuxième couche étant située sur la première couche et comprenant en outre des deuxièmes fibres céramiques dispersées dans ladite deuxième couche. La présence des deuxièmes fibres céramiques permet d'améliorer la tenue mécanique de la deuxième couche et sa résistance aux agressions par les composés CMAS. La deuxième couche peut permettre en outre de boucher les porosités présentes en surface de la première couche afin de mieux la protéger contre l'infiltration par les composés CMAS.

Dans un exemple de réalisation, l'écart entre le coefficient de dilatation thermique du matériau de la deuxième couche et le coefficient de dilatation thermique du matériau des deuxièmes fibres céramiques peut être inférieur ou égal à 4.10⁻⁶ K⁻¹, voire inférieur ou égal à 2.10⁻⁶ K⁻¹.

Dans un exemple de réalisation, les première et deuxième couches peuvent être poreuses, la première couche présentant un premier taux de porosité, et la deuxième couche présentant un deuxième taux de porosité strictement inférieur au premier taux de porosité.

Dans un exemple de réalisation, les deuxièmes fibres céramiques peuvent être constituées d'un matériau choisi parmi les suivants : la zircone stabilisée par un oxyde de terre rare, les oxydes de terres rares, les structures pyrochlores, les zirconates de terres rares, l'alumine Al₂O₃, et leurs mélanges.

Dans un exemple de réalisation, les deuxièmes fibres céramiques peuvent être constituées du même matériau que celui de la deuxième couche céramique.

Dans un exemple de réalisation, la teneur massique en deuxièmes fibres céramiques dans la deuxième couche peut être comprise entre 30% et 90%. Par exemple, la teneur massique en deuxièmes fibres céramiques dans la deuxième couche peut être comprise entre 50% et 90%, voire entre 70% et 90%.

Selon une première alternative de l'invention, la première couche comprend un mélange d'un premier matériau céramique de barrière thermique et d'un deuxième matériau céramique de protection contre les aluminosilicates de calcium et de magnésium, les premier et deuxième matériaux céramiques étant différents, ladite première couche présentant une première zone s'étendant sur une partie de son épaisseur et présentant une première teneur massique en deuxième matériau, et une deuxième zone s'étendant sur une partie de son épaisseur et recouvrant la première zone, la deuxième zone présentant une deuxième teneur massique en deuxième matériau strictement supérieure à la première teneur massique. Cette disposition permet d'obtenir un revêtement de barrière thermique sur la pièce qui présente un gradient de propriétés depuis la première zone jouant principalement le rôle de barrière thermique sur le substrat et la deuxième zone assurant une protection de la première zone plus particulièrement contre les composés CMAS. Lorsqu'une deuxième couche comprenant un matériau céramique de protection contre les aluminosilicates de calcium et de magnésium est présente sur la première couche, ce gradient de composition permet d'assurer une bonne compatibilité thermomécanique entre la première et la deuxième couche.

Dans un exemple de réalisation, le matériau céramique de protection contre les aluminosilicates de calcium et de magnésium peut être choisi parmi les suivants : les oxydes de terre rare, la zircone stabilisée par un oxyde de terre rare, les structures pyrochlores, les zirconates de terres rares, l'alumine Al₂O₃, et leurs mélanges. Par exemple, le matériau céramique de protection contre les CMAS peut être de l'Yttrine Y₂O₃, de la cérine Ce_{0,5}Y_{0,5}O_{1,8}, du zirconate d'yttrium Y₂ZrO₇, du zirconate de gadolinium GdZr₂O₇, de l'alumine Al₂O₃ mélangée à un zirconate de terre rare, etc.

Selon une deuxième alternative de l'invention éventuellement combinable avec la première alternative de l'invention, la première couche est poreuse et comprend une première portion s'étendant sur une partie de son épaisseur présentant un premier taux de porosité, et une deuxième portion s'étendant sur une partie de son épaisseur et recouvrant la première portion, la deuxième portion présentant un deuxième taux de porosité strictement inférieur au premier taux de porosité. Avec cette disposition, la première couche comprend une deuxième portion qui présente une porosité limitée afin de conférer une protection efficace contre l'infiltration par les composés CMAS. Cette deuxième portion est située sur une première portion de la première couche qui présente une porosité plus élevée. La première portion, plus poreuse, permet d'améliorer la résistance de la barrière thermique aux contraintes imposées par l'infiltration éventuelle de composés CMAS.

L'invention vise enfin un procédé de fabrication d'une pièce telle que celle décrite précédemment, le procédé comprenant au moins une étape de formation de la première couche sur la pièce par voie humide. Par « voie humide », on entend notamment les procédés de dépôt du type sol-gel, par trempage-retrait (ou « dip coating »), ou par électrophorèse. Dans un exemple de réalisation, la première couche peut être formée par sol-gel, par trempage-retrait ou par électrophorèse.

### Brève description des dessins

D'autres caractéristiques et avantages de la présente invention ressortiront de la description faite ci-dessous, en référence aux dessins annexés qui en illustrent un exemple de réalisation dépourvu de tout caractère limitatif. Sur les figures :
- les figures 1 à 4 montrent des vues schématiques en coupe de la surface de pièces de turbomachine revêtues selon différents modes de réalisation de l'invention,
- la figure 5 est un ordinogramme illustrant les étapes d'un procédé selon un mode de réalisation de l'invention, et
- la figure 6 est une photographie obtenue par microscopie électronique à balayage montrant une coupe de la surface d'une pièce revêtue obtenue par un procédé selon l'invention.

### Description détaillée de l'invention

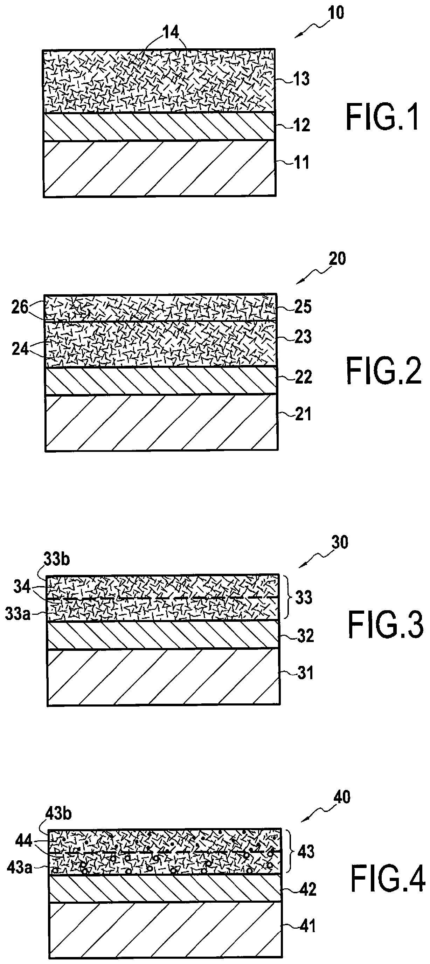

La figure 1 montre une vue agrandie en coupe de la surface d'une pièce de turbomachine 10, comprenant un substrat 11 recouvert, dans cet ordre, par : une sous-couche d'accrochage 12 et une première couche de barrière thermique 13. Dans cet exemple, la sous-couche d'accrochage 12 est directement au contact du substrat 11 et de la première couche 13. Dans cet exemple, la première couche 13 forme une couche externe de la pièce 10. La pièce de turbomachine 10 peut par exemple être une pièce présente dans une partie chaude de la turbomachine, telle qu'une turbine, et constituer par exemple une aube de turbine, une partie d'un anneau de turbine, etc.

Le substrat 11 peut par exemple comprendre un superalliage métallique, par exemple un superalliage à base de nickel, ou un matériau CMC. La sous-couche d'accrochage 12, connue en soi, permet d'assurer une bonne adhésion du premier revêtement de barrière thermique 13 sur le substrat 11. Plus généralement, une telle sous-couche d'accrochage 12 permet d'assurer une bonne compatibilité mécanique entre la première couche de barrière thermique 13 et le substrat 11, en compensant notamment la dilatation thermique différentielle qui pourrait exister entre les matériaux de la première couche 13 et du substrat 11.

Dans le cas où le substrat 11 comprend un superalliage métallique, la sous-couche d'accrochage 12 peut par exemple comprendre un aluminiure simple ou modifié (par exemple NiCrAlY pour un substrat en superalliage à base de nickel), qui peut s'oxyder en partie pour former une couche d'oxyde (aussi appelée TGO pour « Thermally Grown Oxide »). Dans le cas où le substrat 11 comprend un matériau composite à matrice céramique, la sous-couche d'accrochage 12 peut comprendre du silicium ou un siliciure métallique. De manière générale, le matériau de la sous-couche d'accrochage 12 sera adapté en fonction des matériaux formant le substrat 11 et la première couche de barrière thermique 13.

La première couche de barrière thermique 13 peut comprendre, de façon connue en soi, de la zircone stabilisée à l'yttrine (YSZ) ou partiellement stabilisée à l'yttrine (8YSZ), qui présente généralement une structure colonnaire.

La première couche de barrière thermique 13 contient des fibres céramiques 14 qui y sont dispersées. Les fibres 14 peuvent être formées d'un matériau céramique identique à celui de la première couche 13, ou, en variante, d'un matériau différent. Dans tous les cas, on peut veiller à ce que l'écart de coefficient de dilatation thermique entre les matériaux des fibres 14 et de la première couche 13 soit inférieur ou égal à 4.10⁻⁶ K⁻¹, voire à 2.10⁻⁶ K⁻¹, de façon à améliorer leur compatibilité thermomécanique.

La figure 2 montre une autre pièce de turbomachine 20. De manière similaire à la pièce 10 précédemment décrite, la pièce 20 comprend un substrat 21 recouvert par une sous-couche d'accrochage 22 sur laquelle est présente une première couche de barrière thermique 23 chargée par des premières fibres céramiques 24. Dans cet exemple, la première couche de barrière thermique 23 est recouverte par une deuxième couche céramique 25 comprenant un matériau de protection contre les composés CMAS. La sous-couche d'accrochage 22 est, dans cet exemple, directement au contact du substrat 21 et de la première couche 23. De même, la première couche 23 est directement au contact de la deuxième couche 25. La deuxième couche 25 constitue ici une couche externe de la pièce 20.

La deuxième couche céramique 25 comprend, comme la première couche 23, des fibres céramiques 26 (deuxièmes fibres céramiques) qui y sont dispersées. Les premières 24 et deuxièmes 26 fibres céramiques peuvent être identiques, ou en variante, être formées d'un matériau céramique différent. Comme pour les premières fibres céramiques 24, les deuxièmes fibres céramiques peuvent être constituées du même matériau que celui de la deuxième couche 25. En variante, les deuxièmes fibres céramiques 26 peuvent être formées d'un matériau différent de celui de la deuxième couche 25, en veillant par exemple à ce que l'écart de coefficient de dilatation thermique entre les matériaux des deuxièmes fibres 26 et de la deuxième couche 25 soit inférieur ou égal à 4.10⁻⁶ K⁻¹, voire à 2.10⁻⁶ K⁻¹, de façon à améliorer leur compatibilité thermomécanique.

La figure 3 montre une pièce de turbomachine 30 selon une première variante de réalisation de l'invention. De manière similaire à l'exemple précédent, la pièce 30 comprend un substrat 31 recouvert par une sous-couche d'accrochage 32 sur laquelle est présente une première couche de barrière thermique 33 chargée par des premières fibres céramiques 34. La sous-couche d'accrochage 32 est, dans cet exemple, directement au contact du substrat 31 et de la première couche 33. La première couche 33 constitue ici une couche externe de la pièce 30.

Dans cet exemple, la première couche 33 de barrière thermique comprend un mélange d'un premier matériau céramique de barrière thermique et d'un deuxième matériau céramique de protection contre les composés CMAS, différent du premier matériau. Plus précisément, la première couche 33 comprend une première zone 33a s'étendant sur une partie de son épaisseur située du côté du substrat 31 présentant une première teneur massique en deuxième matériau non nulle. La première zone 33a est ici directement au contact de la sous-couche d'accrochage 32. La première couche 33 comprend en outre une deuxième zone 33b située sur la première zone 33a et directement au contact de cette dernière, présentant une deuxième teneur en deuxième matériau strictement supérieure à la première teneur. La première couche de barrière thermique 33 est constituée ici de deux zones consécutives 33a, 33b qui sont empilées l'une sur l'autre. Ainsi, la première couche 33 présente un gradient de composition entre la première 33a et la deuxième zone 33b afin d'améliorer la résistance aux composés CMAS de la barrière thermique sans altérer ses propriétés. Ce gradient de composition permet également d'améliorer, dans le cas où une deuxième couche comprenant un matériau de protection contre les composés CMAS est présente sur la première couche 33, la compatibilité entre la première 33 et la deuxième couche. On notera que la première couche 33 peut présenter un nombre de zones supérieur à deux, en veillant toujours à conserver un gradient de composition dans la première couche 33.

La figure 4 montre une pièce de turbomachine 40 selon une deuxième variante de réalisation de l'invention. De manière similaire à l'exemple précédent, la pièce 40 comprend un substrat 41 recouvert par une sous-couche d'accrochage 42 sur laquelle est présente une première couche de barrière thermique 43 chargée par des premières fibres céramiques 44. La sous-couche d'accrochage 42 est, dans cet exemple, directement au contact du substrat 41 et de la première couche 43. La première couche 43 constitue ici une couche externe de la pièce 40.

Dans cet exemple, la première couche de barrière thermique 43 est poreuse et comprend une première 43a et une deuxième 43b portions qui s'étendent chacune sur une partie de l'épaisseur de la première couche 43. La première portion 43a est située du côté du substrat 41 et est ici directement au contact de la sous-couche d'accrochage 42. La deuxième portion 43b recouvre la première portion 43a et est ici directement au contact de cette dernière. La première portion 43a présente ici un premier taux de porosité non nul, et la deuxième portion 43b présente un deuxième taux de porosité non nul et strictement inférieur au premier taux de porosité. Ainsi, la première couche de barrière thermique 43 présente un gradient de porosité décroissant entre la première 43a et la deuxième 43b portion. Cette disposition permet de réduire l'infiltration par les composés CMAS au niveau de la deuxième portion 43b, d'améliorer la résistance aux contraintes dans la première portion 43a, et, dans le cas où d'autres couches seraient présentes sur la première couche 43, d'améliorer la compatibilité thermomécanique entre ces couches.

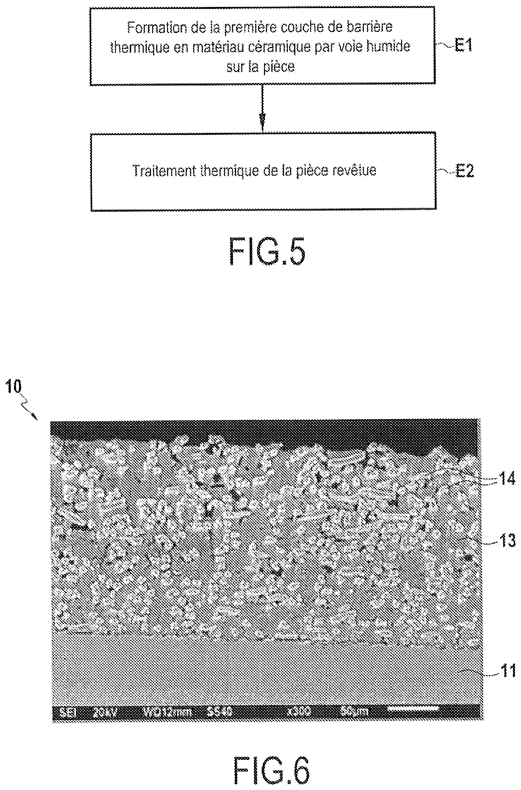

Un procédé de fabrication d'une pièce revêtue 10 va maintenant être décrit en lien avec l'ordinogramme de la figure 5.

Une étape préalable, connue en soi, consiste tout d'abord à déposer sur le substrat 11 la sous-couche d'accrochage 12, par exemple par projection plasma.

Puis dans une étape E1, on forme la première couche 13 de barrière thermique sur la sous-couche d'accrochage 12 par voie humide. Les procédés de dépôt par voie humide comprennent notamment le trempage-retrait (« dip coating ») et l'électrophorèse. Lorsque la première couche 13 est formée par électrophorèse, il peut être avantageux de déposer sur la sous-couche d'accrochage 12 une couche conductrice de l'électricité (par exemple de l'or, de l'argent ou du platine). Pour obtenir une première couche 13 chargée de premières fibres céramiques 14, le bain utilisé pour le dépôt devra comprendre des premières fibres céramiques 14 en suspension qui seront déposées avec le matériau de la première couche 13 sur la pièce 10.

Pour obtenir une première couche qui présente une porosité contrôlée, on pourra introduire dans le bain un agent porogène qui sera éliminé ultérieurement, par exemple des particules de carbone. En variante, pour obtenir une porosité contrôlée, il est possible d'utiliser dans le bain des poudres présentant une morphologie particulière qui peut conférer à la couche déposée une porosité contrôlée. Pour obtenir une première couche qui présente un gradient de composition ou un gradient de porosité, c'est-à-dire des zones ou portions ayant une porosité ou une composition différente, il est possible de réaliser plusieurs dépôts successifs en adaptant la composition du bain utilisé pour chaque dépôt.

On notera qu'il peut être avantageux de déposer, avant le dépôt de la première couche 13 de barrière thermique, une sous-couche intercalaire en un matériau céramique qui n'est pas chargée en fibres céramiques afin d'améliorer l'adhérence de la première couche 13 de barrière thermique sur la sous-couche d'accrochage 12. Cette sous-couche peut également être déposée par voie humide.

Le cas échéant, il est possible de former sur la première couche de barrière thermique 23 une deuxième couche céramique 25 comprenant un matériau de protection contre les composés CMAS et chargée de deuxièmes fibres céramiques 26. Cette deuxième couche 25 peut également être formée par voie humide, de façon connue en soi.

Enfin, dans une étape E2, la pièce 10 ainsi revêtue peut être traitée thermiquement. Au cours de cette étape la formation de la première couche 13 est achevée et, le cas échéant, l'agent porogène présent est éliminé pour libérer la porosité dans la première couche. Lorsque plusieurs couches sont formées sur la pièce, il est possible de réaliser un traitement thermique après le dépôt de chaque couche ou, en variante, après le dépôt de toutes les couches.

### Exemple (pas selon l'invention)

Un procédé a été mis en oeuvre sur une pièce de turbomachine en superalliage à base de nickel (type AM1) recouverte d'une sous-couche d'accrochage du type NiPtAI. On cherche, dans cet exemple, à obtenir une première couche de barrière thermique comprenant une matrice de de zircone stabilisée à l'Yttrine dans laquelle des premières fibres céramiques de zircone stabilisée à l'Yttrine sont dispersées.

On prépare tout d'abord, de façon connue en soi, un premier bain pour obtenir un sol de YSZ, comprenant 7,08 mL de 1-propanol, 0,88 mL de l'acétylacétone, 4,93 mL de propoxyde de zirconium, et 2.36 mL de nitrate d'yttrium.

On prépare ensuite un deuxième bain qui sera utilisé ultérieurement pour revêtir la pièce par trempage-retrait de la première couche de barrière thermique chargée de fibres céramiques. Le deuxième bain comprend du 1-propanol et un dispersant du type PVP 3500 à 1%, dans lequel on a ajouté de la poudre commerciale d'YSZ commercialisée sous la dénomination Tosoh TZ6Y et des fibres céramiques YSZ commercialisées par la société Zircar Zirconia. Dans la partie solide du deuxième bain, la charge massique en poudre d'YSZ est ici égale à 40%m. Toujours dans la partie solide du deuxième bain, la charge massique en fibres céramiques YSZ est ici égale à 60%m. Les fibres céramiques présentent ici une taille inférieure ou égale à 50 µm. La charge massique totale en YSZ dans le bain est de l'ordre de 40%m. Après agitation sous ultrasons et ajout d'eau distillée, une partie du premier bain est ajoutée au deuxième bain. On agite finalement encore le deuxième bain ainsi préparé.

Puis, on procède au dépôt sur la pièce d'une sous-couche intercalaire de sol YSZ de façon à améliorer l'accroche de la première couche de barrière thermique en YSZ chargée de fibres sur la pièce. Pour ce faire, on dépose par trempage-retrait une couche à partir du premier bain préparé précédemment, puis on la sèche à l'étuve à 50°C pendant 5 minutes.

On procède ensuite au dépôt de la première couche en YSZ chargée des premières fibres céramiques en YSZ à partir du deuxième bain préparé précédemment. Pour ce faire, on dépose par trempage-retrait une couche précurseur de la première couche à partir du deuxième bain, puis on la sèche à l'étuve à 50°C pendant 5 minutes. Cette opération est répétée jusqu'à obtention de l'épaisseur voulue. Pour obtenir une épaisseur comprise entre 150 µm et 200 µm, il est généralement nécessaire de réaliser au moins vingt immersions.

Enfin, on traite thermiquement la pièce sur laquelle ont été effectués les dépôts précédents dans un four à l'air libre, tout d'abord à 600°C pendant 1 heure, puis à une température comprise entre 1100°C et 1250°C pendant 2 heures, en faisant varier les températures à 50°C/h entre chaque palier.

On obtient après cette étape la pièce revêtue dont une vue en coupe au microscope électronique à balayage de la surface est visible à la figure 6. La première couche 13 est présente sur le substrat 11 en superalliage AM1. Une sous-couche intercalaire de sol YSZ, non visible sur la photographie de la figure 6, est présente entre le substrat 11 et la première couche 13. La première couche 13 présente une épaisseur moyenne de l'ordre de 180 µm. La photographie montre bien la présence des fibres céramiques 14 au sein de la première couche 13. Le taux de porosité moyen dans la première couche 13 de barrière thermique est ici inférieur à 20%. La première couche 13 de barrière thermique ne présente pas de délaminations ou de fissurations, ce qui traduit une bonne accommodation des contraintes thermomécaniques.

## Revendications

1. Pièce de turbomachine (30; 40) revêtue d'au moins une première couche de barrière thermique (33 ; 43) comprenant un matériau céramique et des premières fibres céramiques (34 ; 44) dispersées dans ladite première couche, **caractérisée en ce que** :
- la première couche comprend un mélange d'un premier matériau céramique de barrière thermique et d'un deuxième matériau céramique de protection contre les aluminosilicates de calcium et de magnésium, les premier et deuxième matériaux céramiques étant différents, ladite première couche présentant une première zone (33a) s'étendant sur une partie de son épaisseur et présentant une première teneur massique en deuxième matériau, et une deuxième zone (33b) s'étendant sur une partie de son épaisseur et recouvrant la première zone, la deuxième zone présentant une deuxième teneur massique en deuxième matériau strictement supérieure à la première teneur massique ; et/ou
- la première couche est poreuse et comprend une première portion (43a) s'étendant sur une partie de son épaisseur présentant un premier taux de porosité, et une deuxième portion (43b) s'étendant sur une partie de son épaisseur et recouvrant la première portion, la deuxième portion présentant un deuxième taux de porosité strictement inférieur au premier taux de porosité.

2. Pièce selon la revendication 1, dans laquelle la teneur massique en premières fibres céramiques (34 ; 44) dans la première couche (33 ; 43) est comprise entre 30% et 90%.

3. Pièce selon la revendication 2, dans laquelle la teneur massique en premières fibres céramiques (14 ; 24 ; 34 ; 44) dans la première couche (33 ; 43) est comprise entre 50% et 90%.

4. Pièce selon l'une quelconque des revendications 1 à 3, dans laquelle la longueur moyenne des premières fibres céramiques (34 ; 44) est inférieure ou égale à 50 µm).

5. Pièce selon l'une quelconque des revendications 1 à 4, dans laquelle les premières fibres céramiques (34 ; 44) sont constituées d'un matériau choisi parmi les suivants : la zircone stabilisée par un oxyde de terre rare, les oxydes de terres rares, les structures pyrochlores, les zirconates de terres rares, l'alumine, et leurs mélanges.

6. Pièce selon l'une quelconque des revendications 1 à 5, dans laquelle la pièce (20) est en outre revêtue par une deuxième couche céramique (25) comprenant un matériau céramique de protection contre les aluminosilicates de calcium et de magnésium, la deuxième couche étant située sur la première couche (23) et comprenant en outre des deuxièmes fibres céramiques (26) dispersées dans ladite deuxième couche.

7. Pièce selon l'une quelconque des revendications 1 à 6, dans laquelle le matériau céramique de protection contre les aluminosilicates de calcium et de magnésium est choisi parmi les suivants : les oxydes de terre rare, la zircone stabilisée par un oxyde de terre rare, les structures pyrochlores, les zirconates de terres rares, l'alumine, et leurs mélanges.

8. Procédé de fabrication d'une pièce selon l'une quelconque des revendications 1 à 7, comprenant au moins une étape de formation de la première couche (33 ; 43) sur la pièce (30 ; 40) par voie humide.

9. Procédé selon la revendication 8, dans lequel la première couche (33 ; 43) est formée par sol-gel, par trempage-retrait ou par électrophèse.

## Patentansprüche

1. Teil einer Turbomaschine (30; 40), das mit zumindest einer ersten thermischen Barriereschicht (33; 43) beschichtet ist, die ein Keramikmaterial und erste Keramikfasern (34; 44) umfasst, die in der ersten Schicht verteilt sind, **dadurch gekennzeichnet, dass**:
- die erste Schicht eine Mischung aus einem ersten thermischen Barriere-Keramikmaterial und einem zweiten Keramikmaterial zum Schutz gegen Calcium- und Magnesium-Aluminosilikate umfasst, wobei das erste und zweite Keramikmaterial verschieden sind, wobei die erste Schicht eine erste Zone (33a), die sich über ein Teilstück ihrer Dicke erstreckt und einen ersten Massegehalt an dem zweiten Material aufweist, und eine zweite Zone (33b) aufweist, die sich über ein Teilstück ihrer Dicke erstreckt und die erste Zone bedeckt, wobei die zweite Zone einen zweiten Massegehalt an dem zweiten Material aufweist, der strikt größer als der erste Massegehalt ist, und/oder
- die erste Schicht porös ist und einen ersten Abschnitt (43a) umfasst, der sich über ein Teilstück ihrer Dicke erstreckt und einen ersten Porositätsgrad aufweist, und einen zweiten Abschnitt (43b), der sich über ein Teilstück ihrer Dicke erstreckt und den ersten Abschnitt bedeckt, wobei der zweite Abschnitt einen zweiten Porositätsgrad aufweist, der strikt kleiner als der erste Porositätsgrad ist.

2. Teil nach Anspruch 1, wobei der Massegehalt an ersten Keramikfasern (34; 44) in der ersten Schicht (33; 34) zwischen 30% und 90% liegt.

3. Teil nach Anspruch 2, wobei der Massegehalt an ersten Keramikfasern (14; 24; 34; 44) in der ersten Schicht (33; 43) zwischen 50% und 90% liegt.

4. Teil nach einem der Ansprüche 1 bis 3, wobei die mittlere Länge der ersten Keramikfasern (34; 44) kleiner als oder gleich 50 µm ist.

5. Teil nach einem der Ansprüche 1 bis 4, wobei die ersten Keramikfasern (34; 44) aus einem Material gebildet sind, das aus den folgenden ausgewählt ist: durch ein Seltenerd-Oxid stabilisiertes Zirkonium, Seltenerd-Oxiden, Pyrochlorstrukturen, Seltenerd-Zirkonaten, Aluminiumoxid und ihren Mischungen.

6. Teil nach einem der Ansprüche 1 bis 5, wobei das Teil (2) ferner mit einer zweiten Keramikschicht (25) beschichtet ist, die ein Keramikmaterial zum Schutz gegen Calcium- und Magnesium-Aluminosilikate umfasst, wobei sich die zweite Schicht auf der ersten Schicht (23) befindet und ferner zweite Keramikfasern (26) umfasst, die in der zweiten Schicht verteilt sind.

7. Teil nach einem der Ansprüche 1 bis 6, wobei das Keramikmaterial zum Schutz gegen Calcium- und Magnesium-Aluminosilikate aus den folgenden ausgewählt ist: Seltenerd-Oxiden, durch ein Seltenerd-Oxid stabilisiertes Zirkonium, Pyrochlorstrukturen, Seltenerd-Zirkonaten, Aluminiumoxid und ihren Mischungen.

8. Verfahren zur Herstellung eines Teils nach einem der Ansprüche 1 bis 7, das zumindest einen Schritt der Bildung der ersten Schicht (33; 43) auf dem Teil (30; 40) im Nassverfahren umfasst.

9. Verfahren nach Anspruch 8, wobei die erste Schicht (33; 43) durch einen Sol-Gel-Prozess, durch Tauchziehen oder durch Elektrophorese gebildet wird.

## Claims

1. A turbine engine part (30; 40) coated in at least a first ceramic layer (33; 43) forming a thermal barrier and comprising a ceramic material with first ceramic fibers (34; 44) dispersed in said first layer, the part being **characterized in that**:
- the first layer comprises a mixture of a first ceramic material for providing a thermal barrier and of a second ceramic material for providing protection against calcium and magnesium aluminosilicates, the first and second ceramic materials being different, said first layer presenting a first zone (33a) extending over a fraction of its thickness and presenting a first weight content of a second material, and a second zone (33b) extending over a fraction of its thickness and covering the first zone, the second zone presenting a second weight content of the second material that is strictly greater than the first weight content; and/or
- the first layer is porous and comprises a first portion (43a) extending over a fraction of its thickness and presenting a first porosity, and a second portion (43b) extending over a fraction of its thickness and covering the first portion, the second portion presenting a second porosity that is strictly less than the first porosity.

2. A part according to claim 1, wherein the weight content of first ceramic fibers (34; 44) in the first layer (33; 43) lies in the range 30% to 90%.

3. A part according to claim 2, wherein the weight content of first ceramic fibers (34; 44) in the first layer (33; 43) lies in the range 50% to 90%.

4. A part according to any one of claims 1 to 3, wherein the mean length of the first ceramic fibers (34; 44) is less than or equal to 50 µm.

5. A part according to any one of claims 1 to 4, wherein the first ceramic fibers (34; 44) are constituted by a material selected from the following: zirconia stabilized by a rare earth oxide; rare earth oxides; pyrochlore structures; rare earth zirconates; alumina; and mixtures thereof.

6. A part according to any one of claims 1 to 5, wherein the part (20) is also coated in a second ceramic layer (25) comprising a ceramic material for providing protection against calcium and magnesium aluminosilicates, the second layer being situated on the first layer (23) and further comprising second ceramic fibers (26) dispersed in said second layer.

7. A part according to any one of claims 1 to 6, wherein the ceramic material for providing protection against calcium and magnesium aluminosilicates is selected from the following: rare earth oxides, zirconium stabilized by an earth oxide; pyrochlore structures; rare earth zirconates; alumina; and mixtures thereof.

8. A method of fabricating a part according to any one of claims 1 to 7, including at least one step of forming the first layer (33; 43) on the part (30; 40) by a wet process.

9. A method according to claim 8, wherein the first layer (33; 43) is formed by a sol-gel process, by dip-coating, or by electrophoresis.
